# EUROPEAN PATENT APPLICATION

(11) **EP 4 567 890 A1**
(43) Date of publication of application: **11.06.2025**
(21) Application number: 23214896.5
(22) Date of filing: 07.12.2023
(51) Int. Cl.: H01L 27/02

(54) **IC ESD PROTECTION WITH DISTRIBUTED SILICON CONTROLLED RECTIFIER**

(71) Applicant: NXP B.V., 5656 AG Eindhoven (NL)
(72) Inventor: Scheucher, Wolfgang, 5656 AG Eindhoven (NL)
(74) Representative: Hardingham, Christopher Mark

(57) **Abstract**

Disclosed is a method and IC, comprising: a p-type substrate layer (410), an ESD protection device (420), and a further region (430); wherein the ESD protection device comprises: a n-well region (422) having therein a n+ contact region (424) and a p+ anode contact region (426), and a trigger device (428) connected between the n+ contact region and a further p+ contact region (446) outside of the n-well, wherein the trigger device is operable, in response to an ESD event trigger, to provide a low-resistance path between the anode contact region and the further p+ contact region; wherein the further region comprises a further n-well (432), spaced apart from the ESD protection device lower-doped n-well region (422); and wherein the further n-well is operable as a cathode of an SCR comprising the anode, and the ESD protection device n-well and the p-doped substrate layer as a n- and p-intermediate nodes.

## Description

### Field

The present disclosure relates to devices and mechanisms to protect integrated circuits, (IC)s from high voltages resulting from electrostatic discharge (ESD) events and the like.

### Background

It is well known that subjecting an integrated circuit (IC) and in particular its input/output pins (I/O pins) to unwanted high voltages can damage or even destroy the functionality of the integrated circuit. Such high voltages are typically the result of electrostatic charge build-up and subsequent discharge, through an electrostatic discharge (ESD) events.

Protection mechanisms against such ESD discharges are well known. Generally, such protection mechanisms provide a low resistance path between the I/O pin and a ground. In order for the low resistance path not to interfere with the normal operation of the IC, ESD protection devices are generally configured such that the low resistance path is operable only when an ESD event has been identified. Since ESD protection devices generally should be designed to be able to dissipate relatively large amounts of charge in relatively short times, they are generally relatively large devices, occupying a significant area of "real estate" of the IC, increasing the size of the IC. It would be desirable to reduce the size of ESD protection devices.

### Summary

According to a first aspect of the present disclosure, there is provided an integrated circuit, IC, comprising: a p-type substrate layer, an electrostatic discharge, ESD, protection device, and a further region; wherein the ESD protection device comprises: a lower-doped n-well region having therein a higher-doped n+ contact region and a higher-doped p+ anode contact region, and a trigger device connected between the n+ contact region and a further higher-doped p+ contact region outside of the n-well, wherein the trigger device is operable, in response to an ESD event trigger, to provide a low-resistance path between the anode contact region and the further higher-doped p+ contact region; wherein the further region comprises a lower-doped n-well, spaced apart from the ESD protection device n-well and connected to a ground; wherein, in response to the trigger device detecting an ESD event, the further region lower-doped n-well is operable as a cathode of a silicon controlled rectifier, SCR, comprising the anode, the ESD protection device lower-doped n-well region as an n-intermediate node, and the p-doped substrate as a p-intermediate node. By making use of the SCR including n-well of one or more further regions, distinct from the ESD protection device itself, it may be possible to reduce the size of the ESD protection device, and in particular the trigger device, since it is not required to dissipate all of the current.

In one or more embodiments the trigger device is a DC level trigger device, and the ESD event trigger is a predetermined voltage across the trigger device. In particular the trigger device may be a grounded gate nmos device (ggnmos). Since ggnmos are well known in the field of ESD protection, use of such a DC level trigger device may simplify the design process.

In one or more other embodiments, the trigger device is a RC trigger device, and the ESD event trigger is a predefined rate of change of voltage across the trigger device exceeding a reference rate of change.

According to one or more embodiments, the SCR comprises a yet further n-well, which yet further n-well is distinct from, and spaced apart from, the further region lower-doped n-well. Use of multiple n-wells may assist in further distributing the ESD current which is required to be dissipated, over a larger area, thus for example minimising local heating effects.

In one or more embodiments the yet further n-well and the ESD protection device are separated by a guard ring. Whereas in conventional devices, it is common to provide isolation between the ESD protection device and the remainder of the circuitry, according to embodiments of the present disclosure, other n-wells may contribute to the ESD protection, even in the presence of some types of guard rings.

According to one or more embodiments the lower-doped n-well of the further active device is connected to the ground via a further device-higher-doped n+ contact region therein.

In one or more embodiments, each of the lower-doped regions have a doping level which is less than 10^17. Moreover, in one or more embodiments each of the higher-doped contact regions have a doping level which is greater than 10^18.

According to one or more embodiments, the IC further comprises a shallow trench isolation region, STI, wherein each of the n-wells are deeper than the STI. One or more of the further device or devices may be separated from the ESD protection device by such an STI, however, since the n-wells are generally deeper than the STI the STI does not provide any impediment to dissipation of the current resulting from the ESD event.

In one or more embodiments the further higher -doped p+ contact region outside of the n-well is connected to the ground. By connecting the contact regions to ground and in particular directly to ground, the dissipation of the current may be assisted.

According to one or more embodiments, the higher-doped p+ contact region is at least twice as large as the further higher-doped p+ contact region outside the n-well. As will become apparent hereinbelow, use of the triggered SCR employing n-wells remote from the ESD device may allow for distributed ESD protection in which the localised ESD protection device and in particular the trigger device does not require to carry all of the ESD current. It may therefore be made smaller than would otherwise be the case

According to a second aspect of the present disclosure, there is provided a method of providing electrostatic discharge, ESD, protection for an anode comprised in an integrated circuit, IC, the method comprising: in response to an ESD event: providing a first discharge path from the anode, the first discharge path comprising a series arrangement of p-n diode in an n-well and a trigger device; and providing a second discharge path comprising a silicon controlled rectifier, SCR, wherein the SCR comprises the p-n diode between the anode and a first intermediate node, a p-type substrate layer, and a further n-well which is spaced apart from the n-well.

In one or more embodiments, the SCR further comprises a yet further n-well, which is spaced apart from both the n-well and the further n-well.

These and other aspects of the invention will be apparent from, and elucidated with reference to, the embodiments described hereinafter.

### Brief description of Drawings

Embodiments will be described, by way of example only, with reference to the drawings, in which
FIG.1A is a simplified circuit diagram of a conventional ESD protection device;
FIG. 1B is an alternative depiction of the circuit of FIG. 1A;
FIG. 2 is a circuit diagram of an alternative ESD protection mechanism, consistent with embodiments of the present disclosure;
FIG. 3 is a cross-sectional schematic of part of an IC showing an ESD protection device according to the circuit of FIG. 1A;
FIG.4 is a cross-sectional schematic of part of an IC according to embodiments of the present disclosure;
FIG. 5 shows the results of modelling the performance of a distributed ESD discharge mechanism according to embodiments of the present disclosure; and
FIG. 6 shows schematically a layout of an IC according to embodiments of the present disclosure.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments.

### Detailed description of embodiments

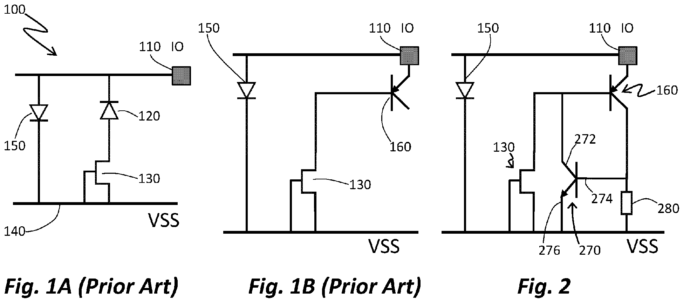

FIG. 1A shows a circuit diagram of a conventional ESD protection device 100, for providing protection against an ESD event in which a high voltage (typically greater than 4V or 24V, or higher voltage, which will depend on the individual design of the IC) it is present on an I/O pin 110 of the device. The ESD protection device comprises a current path of a diode 120 connected in series with a switch 130. The switch 130 may also be referred to as a trigger device since it closes or starts to conduct in response to a trigger event. In the example shown, the switch or trigger device is configured as a grounded gate transistor, and in the example shown is a ggnmos (grounded gate nmos) device. The diode 120 may be conveniently implemented as a p-type depletion (dp) diode. In such a device, if the voltage presented to I/O pin 110 exceeds the threshold voltage of the diode plus voltage required to turn on the switch which in the case of a ggnmos is Vt, the switch opens and current is conducted from the I/O pin to the ground level VSS 140 through the low resistance path comprising the diode and the switch. For completeness it should be noted that protection against reverse voltages may be also provided, in the form of a further diode 150 arranged antiparallel with the low resistance path. It will be appreciated that the diode 120 may be implemented as the emitter-base of a notional PNP transistor 160, as illustrated in FIG. 1B

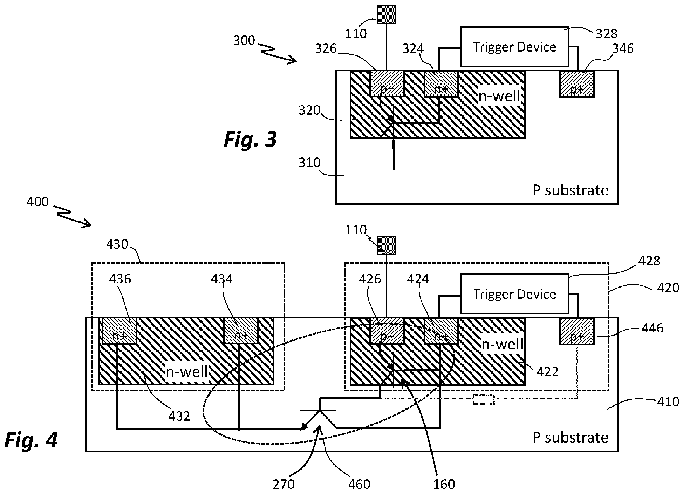

Turning now to FIG. 3, this shows a schematic cross-section through such a conventional ESD protection device 300 as depicted in FIG. 1A. The device is fabricated within a p-type substrate layer 310 of the integrated circuit. As will be familiar to the skilled person, the p-type substrate layer may be an epitaxial layer or may be a bulk substrate. The doping of the layer may be in a range of 10^15 to 10^17 /cm³.. The ESD protection device is partly fabricated within an n-well 320. As will again be familiar to the skilled person, typically an integrated circuit fabricated on a p-type substrate includes a plurality of isolated n-wells - that is to say n-wells which are spaced apart and physically separate, in which one or more devices (also referred to as active devices, or core devices, such as transistors or diodes) are fabricated. N-wells may be isolated from each other simply by their separation, or there may be further isolation barriers, such as shallow trench isolation (STI) which typically comprise a relatively shallow (that is to say the shallower than the n-wells) volume of insulator (such as silicon oxide in the case of silicon ICs) formed at the surface of integrated circuit. Alternatively, guard rings (low resistance paths formed by metal or very high doped semiconductor), or deep trench isolation (insulating material embedded into the device deeper than the typical n-well) may be used to further electrically isolate the n-wells.

Within the n-well 320 is a relatively highly doped p+ contact region 326. The p+ contact region 326 is relatively shallow compared with the n-well, and has a doping level which typically is greater than 10^19 /cm³, or even greater than 10^20 /cm³. The p+ contact region 326 is electrically connected to the I/O pin 110, typically by means of metal tracks and vias through a so-called "metallisation stack" (not shown), as will be familiar to the skilled person. Also within the n-well 320, there is a highly doped n+ region 324. The n+ region 324 is also relatively shallow compared with the n-well, and has a doping level which typically is greater than 10^19 /cm³.

Outside of the n-well 320 is a further relatively high doped p+ contact region 346. A trigger device 328 is connected between the n+ region 324 and the p+ region 346. In figure 3 the trigger device is shown schematically. It may be implemented as a ggnmos, again as will be familiar to the skilled person.

In operation, the p+ region 326 and the n+ region 324, both within the n-well 320, act as a p-type depletion diode, which is in series with the trigger device 328. On the occurrence of an ESD event, the voltage at pin 110 exceeds the sum of the threshold voltage for the p-type depletion diode and the trigger voltage of the trigger device 328, resulting in a low-voltage path from the I/O pin 110 to the p+ contact region 346. Current is dissipated from the p+ contact region 346 to the substrate, and thus to ground, since the substrate layer is electrically connected ground.

Also shown in FIG. 3 is part of the equivalent electrical circuit of the device, in which the diode formed by the p+ contact region 326 and n+ region 324 is depicted as part of (that is to say the emitter and base) of a pnp bipolar transistor in which the collector region is the p+ substrate. This is depicted in FIG. 1 B as bipolar transistor 160, of which the emitter-base diode is connected in series with the switch 130 which in this cases is a ggnmos trigger device.

Turning now to FIG. 2, this illustrates part of the concept of the present disclosure. In addition to the circuit elements of FIG. 1A and FIG. 1B, this circuit diagram depicts a further, npn, bipolar transistor 270, having collector 272 base 274 and emitter 276. The collector 272 of this npn transitor is common with the base of the bipolar transistor 160, and the base of the NPN bipolar transistor 270 is common with the collector of the transistor 160. This arrangement of a npn transistor and a pnp transistor forms a silicon controlled rectifier (SCR), which may also be referred to as a thyristor. This pnpn SCR has the collector 272 as its intermediate n-type node, and base 274 as its intermediate p-type node. Finally, the common collector of pnp transistor 160 and base of npn transistor 270, that is to say the second intermediate p-type node of the SCR, is connected to ground or VSS through a resistor 180, which represents the resistance of the path through the substrate to VSS (that is to say, to the grounded p+ contact regions which will be shown in FIG. 4). A key aspect of the present disclosure is the physical configuration of the emitter 276 of the SCR's npn transistor. Although this is not visible in FIG. 2, this is at least in part remote from the remainder of the device that is to say it results in a SCR which is distributed across the IC. This will be more apparent from FIG. 4.

FIG. 4 shows a schematic cross-section of part of an IC, according to the present disclosure. The figure shows a p-type substrate layer 410, which, as described above, may be an epitaxial layer or may be a bulk substrate, includes an ESD protection device 420 as shown in FIG. 3, and a further region 430. Further region 430 may be part of, or may contain, a further active device of the IC. The IC 400 may include a further higher doped p+ contact region 474 which is spaced apart from both the ESD protection device 420 and the further region 430. The lumped substrate resistance, or "resistance-to-ground" 230 from the base of the NPN transistor is drawn connected to the p+ contact region 446, although it will be appreciated that this lumped resistance includes the path to all the - accessible - grounded p+ higher doped regions, rather than only to that shown at 446 in this part of the IC.. The ESD protection device 420 is the same as that discussed above with respect to FIG. 3 and comprises a diode formed between the highly doped p+ contact region 426 and n-well region 422. In series with the diode is a trigger device 428, shown schematically in the figure, between highly doped n+ contact region 424 and a highly doped p+ contact region 446 which is spaced apart from the n-well 422. As shown in the circuit diagram superimposed on the figure, the p+ region 426 and n+ region 424 form the emitter and base of the first, pnp, bipolar transistor 160, which together with the second, npn, bipolar transistor 270 form a silicon controlled rectifier 460. The collector of the first pnp bipolar transistor is provided by the p-type substrate layer 410. As already discussed, the n+ contact region 424 and the p-type substrate layer 410 respectively form the collector and base of a second, npn, bipolar transistor 270. The emitter of this second, npn bipolar transistor 270 is formed by the n-well 432 of the further region 430, and together the two transistors cooperate to form a silicon controlled rectifier 460.

In operation, in the event that a high voltage, such as that generated by an ESD event, is applied to the I/O pin 110, the diode between the p+ region 426 and n+ region 424 within the n-well starts to conduct, and the high voltage starts to be applied across the trigger device 428. The trigger device turns on, and as a result current flows to the grounded p+ region 446. This conduction has the secondary effect of turning on the first transistor 160 of the SCR, and this in turn turns on the second transistor 270. It will be appreciated that the emitter of the second transistor 270, which forms the cathode of the SCR is not part of the n-well 422, nor part of the ESD device 420 (which may also be referred to as the primary ESD protection device 420). Rather, the conduction through the SCR provides a secondary ESD protection path. Moreover, this path includes an n-well which is not part of the primary ESD protection device 420 but spaced apart therefrom. In particular the n-well acting as the cathode of the thyristor in the secondary ESD protection path may form a part of, or may encompass, a further active device. Since the ESD protection circuit, for dissipating current resulting from an ESD event, includes multiple paths - that is to say at least the trigger device and more importantly the SCR which includes n-wells which are spaced apart a remote from the ESD detection protection device itself, it may be considered that the ESD protection is distributed across, that is to say, includes multiple parts of, at least part of the IC, rather than being localised to the ESD protection device alone.

Although in FIG. 4 a single further n-well spaced apart from the primary ESD protection device 420 is shown, it will be appreciated that the SCR may utilise a plurality of n-wells as distinct cathodes, provided only that they are adjacent to or in electrical contact with the p substrate 410, and that they are grounded, for instance by the highly doped and plus regions 434 and 436 shown. Thus, embodiments of the present disclosure do not require that the complete charge of the ESD event is conducted through the trigger device. Indeed, the charge need not conducted through the ESD protection device 420 - as the term ("ESD protection device") has been used herein. Rather, the charge may be conducted through one or more n-wells which are spaced apart from the ESD protection device itself, and thus may be distributed over or across one or more other parts of the IC. The skilled person will appreciate that this may be beneficial for example the ESD protection device 420 may be sized and dimensioned to be able to carry a lower current than would otherwise be the case. Alternatively, or in addition, the thermal effect of the fast dissipation of the ESD charge may be more uniformly distributed across the IC.

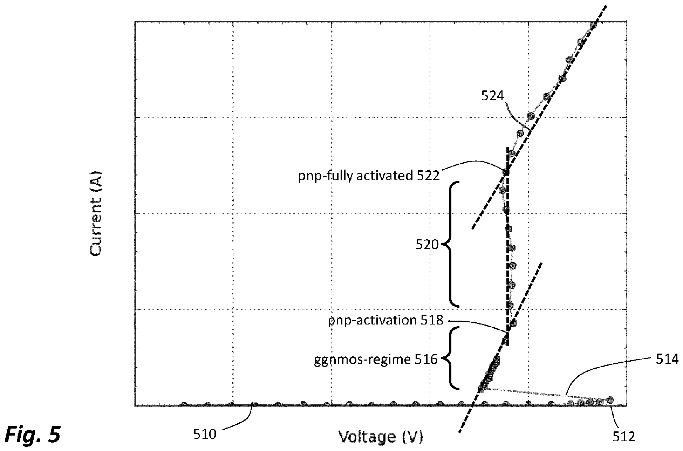

FIG. 5 shows modelling of TLP (transition line pulsing) analysis of the performance of a distributed ESD discharge at an IO of a device such as that shown in FIG. 4. Initially, as the voltage at the I/O pin 110 starts to rise, there is no conduction, as shown at 510. With increasing voltage, at 512 the trigger device switches on and starts to conduct, resulting in a characteristic snap-back behaviour 514. As the current through the trigger device increases, at 518 the SCR including the PNP transistor, having one remote or spaced apart n-well, starts to become active. This resulting in conduction of the thyristor or SCR. As the current continues to increase, over a range 520, the substrate voltage starts to lift locally around the dp diode; the substrate voltage gradient over distance determines the area in which current flows towards one or more additional grounded n-wells which start to conduct, acting as multiple cathodes for the thyristor. This results in the voltage clamping behaviour which is very low-ohmic, as shown over range 520. Once all available n-wells are contributing to the current, a staple relatively low-ohmic clamping behaviour is achieved with a relatively constant effective on resistance, Ron,as shown at 524.

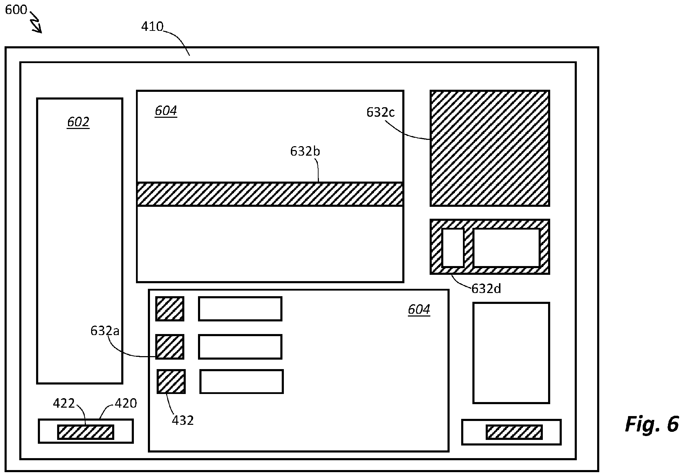

FIG. 6 shows, schematically, a horizontal section through an integrated circuit 600, the section being beneath most of the device layers and in particular beneath the highly doped contact layers and/or metallisation tracks. There is shown a p-type substrate layer on which various devices or components of the IC, such as component 602, 604, 606 are laid out. Also shown is an n-well 422 in which parts (not visible) of an ESD protection device are fabricated. A further n-well which is spaced apart from the ESD protection device is shown at 432. Various other n-wells, which are separated from and thus, under normal conditions (that is to say when there is not an ESD discharge event occurring) electrically isolated from each other are shown at 632a, 632b, 632c, and 632d. As is apparent from the figure, various ones of the n-wells which may be part of the distributed ESD protection current paths may be closer or more remote from the ESD protection device 420.

From reading the present disclosure, other variations and modifications will be apparent to the skilled person. Such variations and modifications may involve equivalent and other features which are already known in the art of ESD protection devices, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

It is noted that one or more embodiments above have been described with reference to different subject-matters. In particular, some embodiments may have been described with reference to method-type claims whereas other embodiments may have been described with reference to apparatus-type claims. However, a person skilled in the art will gather from the above that, unless otherwise indicated, in addition to any combination of features belonging to one type of subject-matter also any combination of features relating to different subject-matters, in particular a combination of features of the method-type claims and features of the apparatus-type claims, is considered to be disclosed with this document.

Features which are described in the context of separate embodiments may also be provided in combination in a single embodiment. Conversely, various features which are, for brevity, described in the context of a single embodiment, may also be provided separately or in any suitable sub-combination.

As used herein, the terms "p-doped" and "p-type", in relation to a semiconductor layer are to be given their general meaning - that is to say p-type dopant atoms, such as, without limitation arsenic (As) or phosphorus (P), atoms in the case of silicon (Si) semiconductor, have been introduced into the semiconductor layer in order to give it a characteristic "p-type" conductivity. Moreover, the terms "n-doped" and "n-type", in relation to a semiconductor layer are to be given the general meaning - that is to say n-type dopant atoms, such as, without limitation boron (B) atoms in the case of silicon (Si) semiconductor, have been introduced into the semiconductor layer in order to give it a characteristic "p-type" conductivity. The terms n-well and p-well shall be interpreted accordingly.

As already mentioned, in one or more embodiments, each of the lower-doped regions have a doping level which is less than 10^17. Such regions may alternatively be referred to as low-doped regions. In one or more embodiments each of the higher-doped contact regions have a doping level which is greater than 10^18. Such regions may alternatively be referred to as highly-doped regions or high-doped regions. In particular the higher doped contact regions are typically doped to a high level in order to minimise the resistance in these regions. Such localised high doping levels are typically provided by ion implantation and the subsequent activation anneal. In contrast, the n-wells are generally much deeper (typically they are deeper than any STI shallow trench isolation structures in the IC, and are doped to a lower level. The lower level doping facilitates over-doping of selected parts of the n-Wells by p-type dopant to result in for instance p+ contact regions for which the doping is not overly compensated by the lower n-type doping.

For the sake of completeness it is also stated that the term "comprising" does not exclude other elements or steps, the term "a" or "an" does not exclude a plurality, a single processor or other unit may fulfil the functions of several means recited in the claims [delete if not relevant] and reference signs in the claims shall not be construed as limiting the scope of the claims. Furthermore, the word "may" is used in a permissive sense (i.e., meaning having the potential to), rather than the mandatory sense (i.e., meaning must). Similarly, the words "include," "including," and "includes" mean including, but not limited to.

## Claims

1. An integrated circuit, IC, comprising:
a p-type substrate layer (410), an electrostatic discharge, ESD, protection device (420), and a further region (430);
wherein the ESD protection device comprises:
a lower-doped n-well region (422) having therein a higher-doped n+ contact region (424) and a higher-doped p+ anode contact region (426), and
a trigger device (428) connected between the n+ contact region and a further higher-doped p+ contact region (446) outside of the n-well,
wherein the trigger device is operable, in response to an ESD event trigger, to provide a low-resistance path between the anode contact region and the further higher-doped p+ contact region;
wherein the further region comprises a further lower-doped n-well (432), spaced apart from the ESD protection device lower-doped n-well region (422) and connected to a ground; and
wherein, in response to the trigger device detecting an ESD event, the further lower-doped n-well is operable as a cathode of a silicon controlled rectifier, SCR, comprising the anode, the ESD protection device lower-doped n-well region as an n-intermediate node, and the p-doped substrate layer as a p-intermediate node.

2. The IC according to claim 1, wherein the trigger device is a DC level trigger device, and the ESD event trigger is a predetermined voltage across the trigger device.

3. The IC according to claim 2, wherein the DC level trigger device is a grounded gate nmos device.

4. The IC according to claim 2, wherein the DC level trigger device is a diode stack.

5. The IC according to claim 1,
wherein the trigger device is a RC trigger device, and the ESD event trigger is a predefined rate of change of voltage across the trigger device exceeding a reference rate of change.

6. The IC according to any preceding claim,
wherein the further region comprises an active device.

7. The IC according to claim 6,
wherein the further lower-doped n-well (432) is connected to the ground via a further higher-doped n+ contact region (434) within the further region.

8. The IC according to any previous claim,
wherein the SCR comprises a yet further n-well, which yet further n-well is spaced apart from the further region lower-doped n-well as well as from the n-well of the ESD protection device.

9. The IC according to claim 8,
wherein the yet further n-well and the ESD protection device are separated by a guard ring.

10. The IC according to any previous claim,
wherein each of the lower-doped regions have a doping level which is less than 10^17 /cm³.

11. The IC according to any previous claim,
wherein each of the higher-doped contact regions have a doping level which is greater than 10^18 /cm³.

12. The IC according to any previous claim,
further comprising a shallow trench isolation region, STI, wherein each of the n-well are deeper than the STI.

13. The IC according to any previous claim,
wherein the further higher -doped p+ contact region (446) outside of the n-well is connected to the ground.

14. The IC according to any preceding claim,
wherein the higher-doped p+ contact region (426) is at least twice as large as the further higher-doped p+ contact region outside the n-well (446).

15. A method of providing electrostatic discharge, ESD, protection for an anode comprised in an integrated circuit, IC, the method comprising:
in response to an ESD event:
providing a first discharge path from the anode, the first discharge path comprising a series arrangement of p-n diode in an n-well and a trigger device; and
providing a second discharge path comprising a silicon controlled rectifier, SCR, wherein the SCR comprises the p-n diode between the anode and a first intermediate node, a p-type substrate layer, and a further n-well which is spaced apart from the n-well.

## Amended claims

### Amended claims in accordance with Rule 137(2) EPC.

1. An integrated circuit, IC, comprising:
a p-type substrate layer (410), a primary electrostatic discharge, ESD, protection device (420), and a further region comprising an active device (430);
wherein the primary ESD protection device comprises:
a lower-doped n-well region (422) having therein a higher-doped n+ contact region (424) and a higher-doped p+ anode contact region (426), and
a trigger device (428) connected between the n+ contact region and a further higher-doped p+ contact region (446) outside of the n-well,
wherein the trigger device is operable, in response to an ESD event trigger, to provide a low-resistance path between the anode contact region and the further higher-doped p+ contact region;
wherein the further region, which is not part of the primary ESD protection device but spaced apart therefrom, comprises a further lower-doped n-well (432) connected to a ground;
wherein the p+ region (426), the n+ region (424), and the p-type substrate layer respectively form an emitter, base, and collector of a first bipolar transistor (160);
wherein the n+ contact region (424), the p-type substrate layer (410), and the further lower-doped n-well (432) respectively form a collector, base and emitter of a second bipolar transistor (270); and
wherein, in response to the trigger device detecting an ESD event, the further lower-doped n-well is operable as a cathode of a silicon controlled rectifier, SCR, (460) comprising the first and second bipolar transistors .

2. The IC according to claim 1,
wherein the trigger device is a DC level trigger device, and the ESD event trigger is a predetermined voltage across the trigger device.

3. The IC according to claim 2,
wherein the DC level trigger device is a grounded gate nmos device.

4. The IC according to claim 2,
wherein the DC level trigger device is a diode stack.

5. The IC according to claim 1,
wherein the trigger device is a RC trigger device, and the ESD event trigger is a predefined rate of change of voltage across the trigger device exceeding a reference rate of change.

6. The IC according to any previous claim,
wherein the further lower-doped n-well (432) is connected to the ground via a further higher-doped n+ contact region (434) within the further region.

7. The IC according to any previous claim,
wherein the SCR comprises a yet further n-well as a distinct cathode of the SCR, which yet further n-well is spaced apart from the further region lower-doped n-well as well as from the n-well of the ESD protection device;
wherein the yet further n-well is in electrical contact with the p-type substrate and grounded.

8. The IC according to claim 8,
wherein the yet further n-well and the ESD protection device are separated by a guard ring.

9. The IC according to any previous claim,
wherein each of the lower-doped regions have a doping level which is less than 10^17 /cm³.

10. The IC according to any previous claim,
wherein each of the higher-doped contact regions have a doping level which is greater than 10^18 /cm³.

11. The IC according to any previous claim,
further comprising a shallow trench isolation region, STI, wherein each of the n-well are deeper than the STI.

12. The IC according to any previous claim,
wherein the further higher -doped p+ contact region (446) outside of the n-well is connected to the ground.

13. The IC according to any preceding claim,
wherein the higher-doped p+ contact region (426) is at least twice as large as the further higher-doped p+ contact region outside the n-well (446).

14. A method of providing electrostatic discharge, ESD, protection for an anode comprised in an integrated circuit, IC, the method comprising:
in response to an ESD event:
providing a first discharge path from the anode at a primary ESD protection device, the first discharge path comprising a series arrangement of p-n diode in an n-well and a trigger device; and
providing a second discharge path comprising a silicon controlled rectifier, SCR, wherein the SCR comprises the p-n diode between the anode and a first intermediate node, a p-type substrate layer, and a further n-well comprised in a further region comprising an active device which is not part of the primary ESD protection device but spaced apart therefrom.
